# FASCICULE DE BREVET EUROPEEN

(11) **EP 1 012 847 B1**
(45) Date de publication et mention de la délivrance du brevet: **26.11.2003**
(21) Numéro de dépôt: 98942836.2
(22) Date de dépôt: 07.09.1998
(51) Int. Cl.: G11C 16/06, H03K 21/40

(54) **PROCEDE D'ENREGISTREMENT D'UN MOT BINAIRE AU MOYEN DE CELLULES MEMOIRE DU TYPE PROGRAMMABLE ET EFFA ABLE ELECTRIQUEMENT**
VERFAHREN ZUM SCHREIBEN VON BINÄREN DATENWÖRTERN MITTELS ELEKTRISCH-PROGRAMMIERBARER UND LÖSCHBARER SPEICHERZELLEN
METHOD FOR RECORDING A BINARY WORD USING ELECTRICALLY ERASABLE AND PROGRAMMABLE MEMORY CELLS

(30) Priorité: 10.09.1997 FR 9711209
(43) Date de publication de la demande: 28.06.2000
(73) Titulaire: Inside Technologies, 69930 Saint-Clément-les-Places (FR)
(72) Inventeur: KOWALSKI, Jacek, F-13530 Trets (FR)
(74) Mandataire: Marchand, André
(86) Numéro de dépôt international: FR9801910
(87) Numéro de publication internationale: WO99013474

(56) Documents cités:
- EP-A- 0 067 364
- EP-A- 0 618 591
- WO-A-97/30454
- US-A- 4 517 663
- US-A- 5 286 415
- PATENT ABSTRACTS OF JAPAN vol. 096, no. 006, 28 juin 1996 & JP 08 044832 A (CITIZEN WATCH CO LTD), 16 février 1996

## Description

La présente invention concerne les mémoires EEPROM (Electricaly Erasable and Programmable Read Only Memory), c'est-à-dire les mémoires rémanentes effaçables et programmables électriquement.

Les mémoires EEPROM ont connu ces dernières années un important développement en raison de leurs caractéristiques avantageuses. En effet, ces mémoires peuvent être programmées ou effacées à volonté par application d'une haute tension Vpp, généralement, de l'ordre de 15 à 20 V. Une fois programmées, elles conservent une information indéfiniment, sans alimentation électrique. En raison de ces propriétés, les mémoires EEPROM représentent le moyen préféré pour l'enregistrement de données d'identification ou transaction dans les circuits intégrés montés sur des supports portables, par exemple les circuits intégrés des cartes à puce ou des étiquettes électroniques.

Toutefois, de tels circuits intégrés ne sont généralement pas protégés contre une coupure intempestive de leur tension d'alimentation Vcc, qui peut se produire à tout instant suite à une erreur de manipulation de l'utilisateur (par exemple le fait de retirer soudainement une carte à puce du lecteur dans lequel elle est insérée) ou une mauvaise réception de l'énergie (notamment quand la tension d'alimentation Vcc est reçue par induction électromagnétique).

Comme la haute tension Vpp de programmation ou d'effacement est généralement produite à partir de la tension d'alimentation Vcc, une coupure intempestive de la tension Vcc au cours d'une opération d'enregistrement peut avoir comme conséquence la perte de la donnée en cours d'enregistrement.

En effet, dans une mémoire EEPROM, l'enregistrement d'un mot binaire nécessite une étape d'effacement du mot précédemment enregistré, puis une étape d'enregistrement du nouveau mot par programmation à 0 de cellules de la mémoire. Cette particularité d'un enregistrement en deux étapes est bien connue de l'homme de l'art et est inhérente à l'agencement interne, en lignes de mot, des cellules mémoire, les cellules d'une même ligne de mot pouvant être programmées à 0 individuellement mais devant être effacées collectivement. Rappelons que l'état programmé d'une cellule mémoire programmable et effaçable électriquement est considéré par convention comme le "0" logique et correspond à l'absence d'électrons dans une grille flottante. L'état effacé correspond au "1" logique et au stockage d'électrons dans une grille flottante.

Ainsi, par exemple, l'enregistrement du mot M = 00110101 à une adresse mémoire comprenant le mot précédent M = 01001101 implique tout d'abord l'effacement du mot précédent, de telle sorte que M = 11111111, puis la programmation à 0 des bits de rang 1, 3, 4 et 7, de telle sorte que M = 00110101.

De façon générale, la disparition de la tension d'alimentation Vcc pendant l'enregistrement d'un mot binaire peut intervenir :
1) pendant l'effacement du mot précédent (risque d'inscription de données aberrantes),
2) pendant la programmation à 0 des bits du nouveau mot (risque d'inscription de données aberrantes),
3) après l'effacement du mot précédent et avant la programmation à 0 des bits du nouveau mot (le nouveau mot autant que le mot précédent sont irrémédiablement perdus).

Dans la demande WO97/48100, la demanderesse a proposé une méthode avantageuse permettant d'achever une opération de programmation ou d'effacement en cours lorsqu'une coupure de la tension d'alimentation Vcc se produit. En résumé, cette méthode consiste, d'une part, à maintenir la haute tension Vpp par une charge de condensateur et, d'autre part, à maintenir les divers chemins électriques conduisant la tension Vpp aux cellules mémoire. Toutefois, cette méthode concerne les cas 1) et 2) ci-dessus et ne permet pas, dans le cas 3), de récupérer le mot perdu et d'entreprendre une opération de programmation.

Par ailleurs, dans les circuits intégrés à microprocesseur, il est connu de prévoir, sous forme de logiciel, un système complexe de sauvegarde mémoire permettant de restaurer la mémoire en cas de coupure d'alimentation. Toutefois, cette méthode ne permet pas de retrouver le mot qui devait être inscrit dans la mémoire après l'effacement de l'ancien mot. De plus, cette méthode n'est pas applicable aux circuits intégrés à logique câblée ne comportant pas de microprocesseur (cartes à mémoire, étiquettes électroniques,...). Dans ces derniers circuits, le problème n'est pas géré et est considéré comme un inconvénient inhérent à l'utilisation des mémoires EEPROM.

Enfin, la demande EP 618 591 ou son équivalent US 5 473 564 décrit une méthode faisant intervenir une cellule auxiliaire associée à chaque ligne de mot d'une mémoire compteur de type "boulier". La cellule auxiliaire permet de savoir, après une coupure de la tension d'alimentation, qu'un bit d'une ligne de poids fort a été programmé à 0 mais que la ligne de poids inférieur n'a pas été correctement effacée à 1. Cette méthode concerne spécifiquement les compteurs bouliers des cartes à prépaiement et ne résout pas le problème technique général exposé ci-dessus.

Enfin, le document WO97/30454 décrit une mémoire scindé en deux plans mémoire en parallèle et enseigne d'enregistrer un mot binaire dans une ligne de l'un des deux plans mémoire, par programmation des cellules mémoire de cette ligne, tout en effaçant dans l'autre plan mémoire une ligne correspondante, parallèle à la ligne programmée, les mots étant enregistrés en alternance dans l'un ou l'autre des plans mémoire. L'objectif visé dans cet enseignement est l'accélération du processus d'écriture dans les mémoires EEPROM.

La présente invention propose d'utiliser à des fins différentes l'idée d'une programmation et d'un effacement simultané de lignes, afin de protéger une mémoire contre les coupures de tension d'alimentation pouvant intervenir entre l'étape d'effacement et l'étape de programmation.

Toutefois, une mémoire telle que décrite par WO97/30454 présente un encombrement non négligeable, égal au double de l'encombrement d'une mémoire classique, puisque le plan mémoire est dédoublé en deux plans mémoire identiques.

Ainsi, un premier objectif de la présente invention est de prévoir un procédé permettant d'enregistrer un mot binaire de façon sécurisée au regard des risques de coupure d'une tension alimentation, applicable à une mémoire d'encombrement réduit.

Un second objectif de la présente invention est de prévoir une mémoire de faible encombrement permettant de mettre en oeuvre ce procédé.

Par ailleurs, le problème technique exposé ci-dessus concerne également les compteurs de données réalisés à partir de cellules mémoire programmables et effaçables électriquement, par exemple les compteurs d'unité des cartes à mémoire.

Ainsi, un troisième objectif de la présente invention est de prévoir une méthode et un compteur pour enregistrer une donnée de comptage de façon sécurisée, c'est-à-dire sans risque de perdre la donnée de comptage en cas de disparition de la tension d'alimentation entre l'étape d'effacement et l'étape de programmation de la ligne de comptage.

Le premier objectif de la présente invention est atteint par la prévision d'un procédé d'enregistrement de mot binaire conforme à la revendication 1.

Le second objectif de la présente invention est atteint par la prévision d'une mémoire à faible encombrement conforme à la revendication 3, utilisable pour la mise en oeuvre du procédé du procédé selon la revendication 1.

Le troisième objectif selon l'invention est atteint par la prévision d'une mémoire conforme à la revendication 7 ou à la revendication 10, comprenant un compteur binaire ou un compteur boulier protégé contre les coupures intempestives d'une tension d'alimentation.

Ces caractéristiques et avantages ainsi que d'autres de la présente invention seront exposés plus en détail dans la description suivante de la méthode de l'invention, de divers modes de réalisation d'un système de mémoire selon l'invention, et de divers modes de réalisation de compteurs d'unités selon l'invention, en relation avec les figures jointes parmi lesquelles :
- la figure 1 est le schéma électrique d'une mémoire EEPROM classique,
- la figure 2 est le schéma électrique d'un premier mode de réalisation d'un système de mémoire EEPROM selon l'invention,
- la figure 3 est le schéma électrique détaillé d'un élément du système de la figure 2,
- la figure 4 est le schéma électrique d'un deuxième mode de réalisation d'un système de mémoire EEPROM selon l'invention,
- la figure 5 est le schéma électrique de cellules témoins selon l'invention, représentées sous forme de blocs en figure 4,
- la figure 6 est le schéma électrique d'un compteur boulier selon l'invention,
- le figure 7 est le schéma électrique d'un compteur binaire selon l'invention, et
- la figure 8 est le schéma logique d'un élément de vérification du compteur de la figure 7.

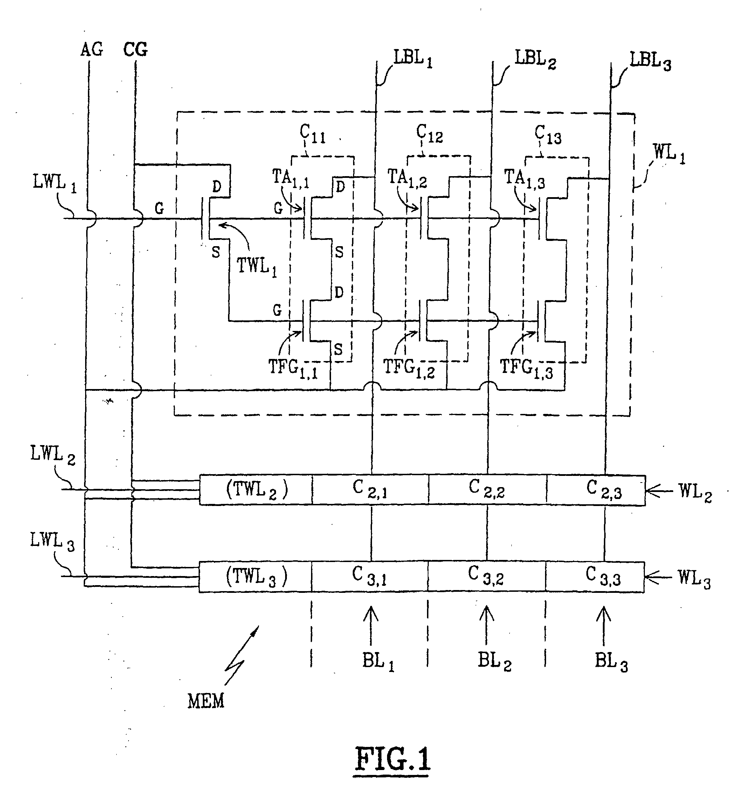

La figure 1 représente, pour mémoire, l'architecture d'une mémoire MEM programmable et effaçable électriquement. La mémoire MEM comprend des cellules C_{i,j} agencées en lignes de mot WLᵢ (lignes horizontales) et lignes de bits BLⱼ (lignes verticales, ou colonnes), "i" étant un indice de ligne de mot et j un indice de ligne de bit. Dans un souci de simplicité, la mémoire MEM représentée ne comprend que neuf cellules C_{i,j} formant trois lignes de mot WL1, WL2, WL3 et trois lignes de bits BL1, BL2, BL3, la ligne de mot WL1 étant représentée en détail.

Chaque cellule mémoire C_{i,j} comprend un transistor d'accès TA_{i,j} et un transistor à grille flottante TFG_{i,j} connecté par son drain D à un transistor d'accès TA_{i,j}. Les sources S de tous les transistors TFG_{i,j} sont connectées à un fil de commande commun AG (ou piste conductrice). Les grilles G des transistors à grille flottante TFG_{i,j} d'une même ligne de mot WLᵢ (même indice i) sont connectées à la source S d'un transistor TWLᵢ de sélection de la ligne de mot WLᵢ. Les drains D des transistors TWLᵢ de sélection des lignes de mot sont connectés à un fil de commande commun CG. Les grilles G des transistors d'accès TA_{i,j} d'une même ligne de mot WLᵢ, ainsi que la grille G du transistor de sélection TWLᵢ de la ligne de mot, sont connectées à un fil LWLᵢ de sélection de la ligne de mot WLᵢ. Les drains D des transistors d'accès TA_{i,j} d'une même ligne de bits BLⱼ (même indice j) sont connectés à un fil LBLⱼ d'accès à la ligne de bits BLⱼ.

De façon classique, l'effacement d'une ligne de mot WLᵢ nécessite les étapes suivantes :
- application d'une haute tension Vpp sur le fil LWLᵢ de sélection de la ligne de mot WLᵢ à effacer,
- application de la tension Vpp sur le fil de commande CG,
- mise à la masse du fil de commande AG,
- les fils d'accès LBLⱼ peuvent être laissés à un potentiel flottant, ou connectés à la masse.

Dans ce cas, les transistors à grille flottante TFG_{i,j} de la ligne de mot WLᵢ sélectionnée reçoivent la tension Vpp sur leur grille G et la masse sur leur source S. Des charges électriques sont injectées par effet tunnel dans les grilles flottantes, de sorte que les transistors présentent ensuite une tension de seuil VT négative et sont naturellement dans l'état non passant (bloqué) au cours d'une lecture de la mémoire. L'état effacé des transistors, c'est-à-dire naturellement non passant, est considéré par convention comme le "1" logique.

Par ailleurs, la programmation de cellules mémoire C_{i,j} d'une ligne de mot WLᵢ nécessite les opérations suivantes :
- application de la haute tension Vpp sur le fil LWLᵢ de sélection de la ligne de mot WLᵢ comprenant des cellules C_{i,j} à programmer,
- mise à la masse du fil de commande CG,
- le fil de commande AG est porté à un potentiel flottant,
- application de la tension Vpp sur les fils LBLⱼ d'accès aux lignes de bits BLⱼ comprenant des cellules devant être programmées.

Dans ce cas, les transistors à grille flottante TFG_{i,j.} appartenant à la ligne de mot WLᵢ sélectionnée et dont les transistors d'accès TA_{i,j} sont connectés à des fils LBLⱼ recevant la tension Vpp, reçoivent la tension Vpp sur leur drain D et ont leur grille G à la masse. Des charges électriques sont libérées des grilles flottantes. Les transistors présentent ensuite une tension de seuil VT positive et sont naturellement dans l'état passant au cours d'une lecture de la mémoire. L'état programmé des transistors, c'est-à-dire naturellement passant, est considéré comme le "0" logique. Les autres transistors TFG_{i,j} de la ligne de mot sélectionnée WLᵢ, qui ne reçoivent pas la tension Vpp sur leur drain D, restent dans leur état initial, effacé ou programmé.

Ainsi, comme indiqué au préambule, la programmation de cellules de la mémoire peut être faite individuellement alors que l'effacement est collectif pour une ligne de mot. L'enregistrement d'un mot binaire dans la mémoire nécessite donc une première étape d'effacement d'une ligne de mot WLᵢ suivie d'une deuxième étape d'enregistrement du mot par programmation à 0 de certains bits de la ligne de mot, choisis en fonction de mot à enregistrer.

### Premier mode de réalisation de l'invention

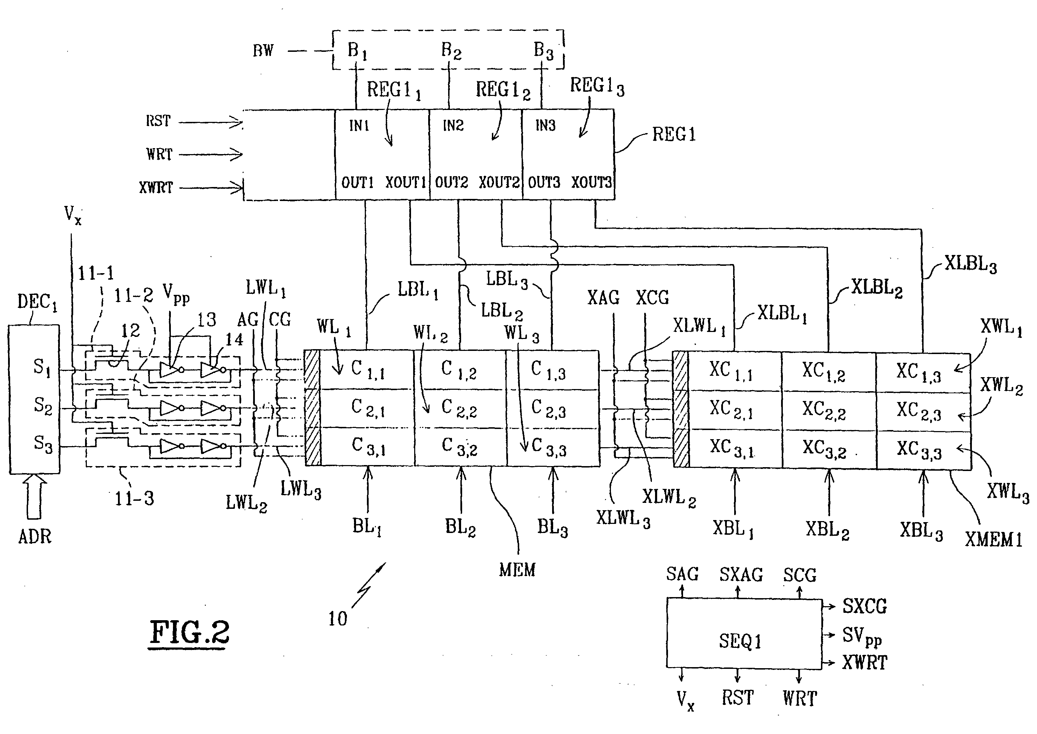

La figure 2 représente un système 10 de mémoire selon l'invention. Le système 10 comprend la mémoire MEM qui vient d'être décrite et une mémoire auxiliaire XMEM1, ici de même structure que la mémoire MEM. La mémoire XMEM1 comprend des cellules XC_{i,j} agencées en trois lignes de mot XWLᵢ et trois lignes de bits XBLⱼ, des fils de commande XAG, XCG, un fil XLWLᵢ de sélection des lignes de mot XWLᵢ, et un fil XLBLⱼ d'accès aux lignes de bits LBLⱼ. Les deux mémoires sont connectées en parallèle, chaque fil LWLᵢ de sélection d'une ligne de mot de la mémoire MEM étant connecté à un fil XLWLᵢ de sélection d'une ligne de mot de même rang i de la mémoire XMEM1. Les fils de sélection LWLᵢ sont pilotés par les sorties Sᵢ d'un décodeur DEC1 d'adresse ADR, par l'intermédiaire de registres à verrouillage (latch) 11-i. De façon classique, ces registres 11-i transforment des signaux basse tension Vcc délivrés par les sorties Sᵢ du décodeur DEC1 en signaux haute tension Vpp, pour la sélection des lignes de mot WLᵢ et XWLᵢ pendant des opérations de programmation ou d'effacement.

Ici, chaque registre à verrouillage 11-i comporte un transistor d'isolement 12 dont la grille est commandée par un signal de validation Vx, et deux portes inverseuses 13, 14 alimentées par la tension Vpp. Chaque interrupteur 12 est agencé entre une sortie Sᵢ du décodeur DEC1 et l'entrée d'une porte inverseuse 13. La sortie de chaque porte 13 est appliquée à l'entrée d'une porte 14. La sortie de chaque porte 14 est ramenée sur l'entrée de la porte 13 et est connectée à un fil LWLᵢ de la mémoire MEM.

Les bits Bⱼ d'un mot binaire BW à enregistrer dans la mémoire MEM sont appliqués sur les entrées INⱼ d'un registre REG1. Le registre REG1 comprend des sorties OUTⱼ connectées aux fils LBLⱼ des lignes de bits BLⱼ de la mémoire MEM, et des sorties XOUTⱼ connectées aux fils XLBLⱼ des lignes de bits XBLⱼ de la mémoire XMEM1. Les sorties OUTⱼ du registre REG1 sont validées par un signal WRT et les sorties XOUTⱼ validées par un signal XWRT. Un signal RST permet d'effacer le registre REG1.

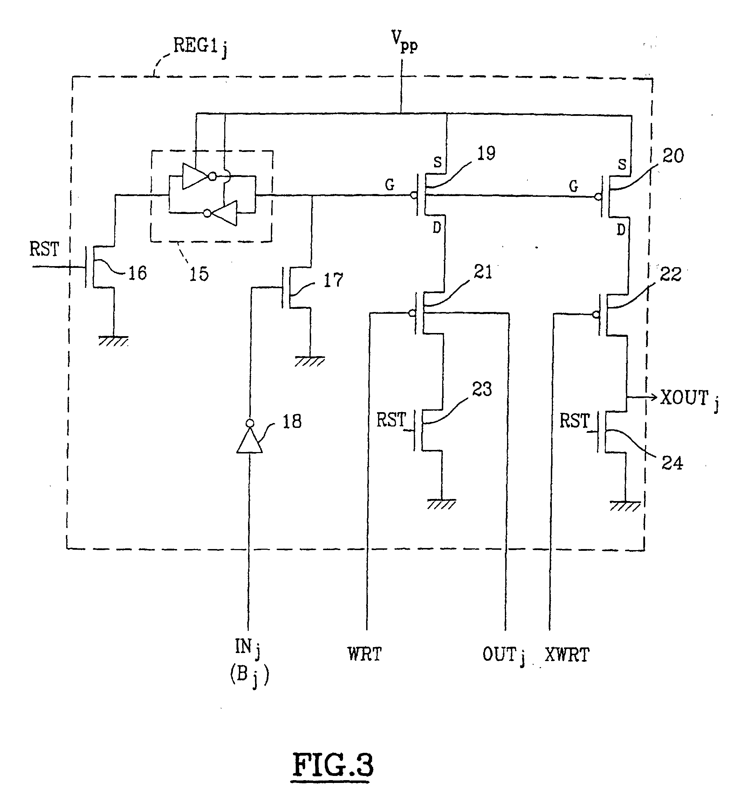

La figure 3 représente un élément REG1ⱼ de rang j du registre REG1, comportant une entrée INⱼ, une sortie OUTⱼ et une sortie XOUTⱼ. L'élément REG1ⱼ comprend une bascule inverseuse 15 alimentée par la tension Vpp. L'entrée de la bascule 15 peut être forcée à 0 par un transistor NMOS 16 piloté par le signal RST. La sortie de la bascule 15 peut être forcée à 0 par un transistor NMOS 17 piloté par l'entrée INⱼ par l'intermédiaire d'une porte inverseuse 18. La sortie de la bascule 15 pilote deux transistors PMOS 19, 20 alimentés par la tension Vpp. Le drain D du transistor 19 est connecté à la sortie OUTⱼ par l'intermédiaire d'un transistor d'isolement PMOS 21 piloté par le signal WRT. Le drain D du transistor 20 est connecté à la sortie XOUTⱼ par l'intermédiaire d'un transistor d'isolement PMOS 22 piloté par le signal XWRT. Des transistors NMOS 23, 24 pilotés par le signal RST peuvent être prévus pour décharger les noeuds des sorties OUTⱼ et XOUTⱼ de la tension Vpp.

L'élément REG1ⱼ fonctionne comme suit. La sortie de la bascule 15 est forcée à 0 quand un bit Bⱼ égal à 0 est appliqué sur l'entrée INⱼ. Dans ce cas, la sortie OUTⱼ délivre la tension Vpp si le signal WRT est à 0, et la sortie XOUTⱼ délivre la tension Vpp si le signal XWRT est à 0. Quand les signaux WRT et XWRT sont à 1, les sorties OUTⱼ et XOUTⱼ sont dans l'état flottant, ou état "HZ" (haute impédance). Inversement, quand un bit Bⱼ à 1 est appliqué sur l'entrée INⱼ après effacement de l'élément REG1ⱼ au moyen du signal RST, la sortie de la bascule 15 délivre la tension Vpp ("1" logique) et les transistors PMOS 19, 20 sont bloqués. Dans ce cas, les sorties OUTⱼ et XOUTⱼ sont flottantes quelle que soit la valeur des signaux WRT et XWRT.

Le système 10 selon l'invention fonctionne en deux étapes que l'on décrira maintenant en référence à la figure 2.

### ETAPE ERAMEM

Cette étape comprend les opérations suivantes : le registre REG1 est effacé par le signal RST, les bits Bⱼ du mot binaire BW à enregistrer sont appliqués sur les entrées INⱼ. Le signal XWRT est mis à 0 (validation des sorties XOUTⱼ) et le signal WRT laissé à 1. Les fils XLBLⱼ de la mémoire XMEM1 qui sont connectés à la sortie XOUTⱼ d'un élément REG1ⱼ ayant reçu sur son entrée INⱼ un bit Bⱼ de valeur 0, reçoivent la tension Vpp. Les autres fils XLBLⱼ sont à un potentiel flottant. Tous les fils LBLⱼ de la mémoire MEM sont à un potentiel flottant, le signal WRT étant à 1. Le signal Vx est appliqué aux registres à verrouillage 11-i, de sorte que la tension Vpp est appliquée sur un fil LWLᵢ de la mémoire MEM, sélectionné par le décodeur DEC1 en fonction de l'adresse ADR reçue. Le fil XLWLᵢ de la mémoire XMEM1 qui est connecté au fil LWLᵢ reçoit également la tension Vpp. Par ailleurs, les fils de commande XCG et AG sont connectés à la masse, le fil XAG est laissé flottant, et la tension Vpp est appliquée au fil CG.

Au cours de cette étape, la ligne de mot WLᵢ de la mémoire MEM, sélectionnée par l'adresse ADR est effacée. Simultanément, le mot binaire BW est enregistré dans la ligne de mot XWLᵢ correspondante de la mémoire auxiliaire XMEM1, par programmation à 0 de certaines cellules de cette ligne. Pour que cette étape s'effectue correctement, on suppose que la ligne de mot XWLᵢ était préalablement effacée.

### ETAPE PGRMEM

Cette étape est l'inverse de l'étape précédente. La mémoire MEM est configurée comme l'était la mémoire XMEM1 à l'étape précédente, et réciproquement. En particulier, le signal WRT est mis à 0 et le signal XWRT est mis à 1, les fils CG et XAG sont connectés à la masse, le fil AG est laissé flottant, et la tension Vpp est appliquée au fil XCG. Les fils LBLⱼ de la mémoire MEM correspondant à des bits Bⱼ de valeur 0 reçoivent la tension Vpp, par les sorties OUTⱼ du registre REG1. Les autres fils LBLⱼ de la mémoire MEM sont portés à un potentiel flottant, ainsi que tous les fils XLBLⱼ de la mémoire XMEM1.

Au cours de cette deuxième étape, la ligne de mot XWLᵢ de la mémoire XMEM1, contenant le mot binaire BW, est effacée. Simultanément, le mot binaire BW est enregistré dans la ligne de mot sélectionnée WLᵢ de la mémoire MEM, par programmation à 0 de certaines cellules de cette ligne. Cette étape s'effectue correctement puisque la ligne de mot sélectionnée WLᵢ de la mémoire MEM a été effacée au cours de l'étape précédente. De plus, avantageusement, l'effacement de la ligne de mot XWLᵢ permet de garantir que cette ligne pourra recevoir un nouveau mot à enregistrer au cours d'une étape ERAMEM ultérieure.

Ce procédé, consistant à enregistrer un mot dans une mémoire auxiliaire pendant l'effacement de la mémoire principale, puis à effacer la mémoire auxiliaire pendant l'enregistrement du mot dans la mémoire principale, offre une bonne protection contre les coupures de la tension d'alimentation Vcc et de la tension programmation Vpp intervenant entre ces deux étapes.

Ainsi, quand le système 10 est mis sous tension, on lit la mémoire auxiliaire XMEM1 qui doit ne contenir que des lignes de mot effacées. En d'autres termes, tous les bits de la mémoire XMEM1 doivent être à "1". Si une ligne de mot de la mémoire XMEM1 contient des bits dans l'état programmé, c'est-à-dire à "0", cela signifie qu'une coupure d'alimentation est intervenue entre l'étape ERAMEM et l'étape PGRMEM. Dans ce cas on charge dans le registre REG1 le mot contenu dans la mémoire auxiliaire XMEM1 et on déclenche l'étape PGRMEM. Dans un souci de simplicité et de clarté des figures, on n'a pas décrit et représenté les diverses connexions internes et les divers circuits permettant de lire les mémoires MEM et XMEM1, qui sont connus de l'homme de l'art.

Le procédé de l'invention peut être exécuté de façon automatique par tout type de circuit intégré, à microprocesseur ou à logique câblée. Les étapes ERAMEM et PGRMEM, ainsi que l'étape de vérification du contenu de la mémoire auxiliaire XMEM1 à la mise sous tension, peuvent être gérées par un microprocesseur ou par un séquenceur à logique câblée SEQ1 représenté en figure 2. Ce séquenceur, d'une structure simple à la portée de l'homme de l'art, délivre les signaux Vx, RST, WRT, XWRT, SVpp, SAG, SCG, SXAG, SXCG nécessaires à l'exécution des deux étapes. Le signal SVpp est un signal d'activation d'un circuit survolteur de type classique produisant la haute tension Vpp (non représenté). Les signaux SAG, SCG, SXAG, SXCG sont des signaux pour piloter des transistors (non représentés) permettant classiquement de connecter les fils AG, CG, XAG et XCG à la masse, à la tension Vpp ou de les laisser flottants.

Par ailleurs, une variante du procédé de l'invention consiste à utiliser les mémoires MEM et XMEM1 en tandem, c'est-à-dire en alternance, pour le stockage permanent des données. Dans ce cas, avant chaque nouvel enregistrement d'une donnée, on détermine, parmi les deux mémoires MEM, XMEM1, celle qui présente à l'adresse ADR envoyée au décodeur DEC1 une ligne de mot dans l'état effacé pouvant recevoir la donnée. On déclenche ensuite l'étape PGRMEM ou l'étape ERAMEM, selon que la donnée doit être enregistrée dans la mémoire MEM ou XMEM1. La détermination de la mémoire MEM ou XMEM1 ayant une ligne de mot effacée à l'adresse ADR peut consister en une simple opération de lecture individuelle des deux mémoires. On peut aussi associer à chaque ligne de mot une cellule témoin CELᵢ du type décrit plus loin. Le mot binaire est alors enregistré automatiquement dans la ligne de mot dont la cellule témoin est programmée (ligne effacée). Simultanément l'autre ligne de mot est effacée, et sa cellule témoin est programmée, en prévision de l'enregistrement ultérieur d'un nouveau mot binaire.

Dans cette variante de réalisation où les données se trouvent indifféremment dans l'une ou l'autre des mémoires MEM et XMEM1, les deux mémoires peuvent être lues en parallèle de façon simultanée. En effet, une cellule mémoire à 1 (effacée) est non passante et une cellule mémoire à 0 (programmée) est passante. Le "0" est donc prioritaire sur le "1" en lecture parallèle. D'autre part, parmi deux lignes de mot de même adresse ADR, une ligne se trouve toujours dans l'état effacé (tous les bits à 1) en vertu du procédé de l'invention. Ainsi, la lecture simultanée de deux lignes de mot dans les mémoires MEM, XMEM1 donne le mot binaire contenu dans la ligne qui n'est pas effacée. Cette lecture simultanée et parallèle de deux lignes de mot peut également être faite de façon logique en envoyant deux par deux, dans des portes ET, les bits de même rang contenus dans les deux lignes de mot.

Dans un souci de simplicité, on s'est limité dans la présente description à une structure de mémoires MEM et XMEM1 comprenant neuf cellules. Il est bien évident qu'en pratique la présente invention est susceptible de s'appliquer à des mémoires de grande taille, comprenant par exemple un grand nombre de lignes de mot de 8 ou 16 bits chacune.

Dans cette perspective, le mode de réalisation qui vient d'être décrit peut nécessiter une surface de silicium importante, car la prévision d'une mémoire auxiliaire XMEM1 de même taille que la mémoire MEM conduit à doubler la taille du plan mémoire.

Aussi, on décrira maintenant un deuxième mode de réalisation de l'invention, dans lequel la taille de la mémoire auxiliaire est ramenée au strict minimum.

### Deuxième mode de réalisation de l'invention

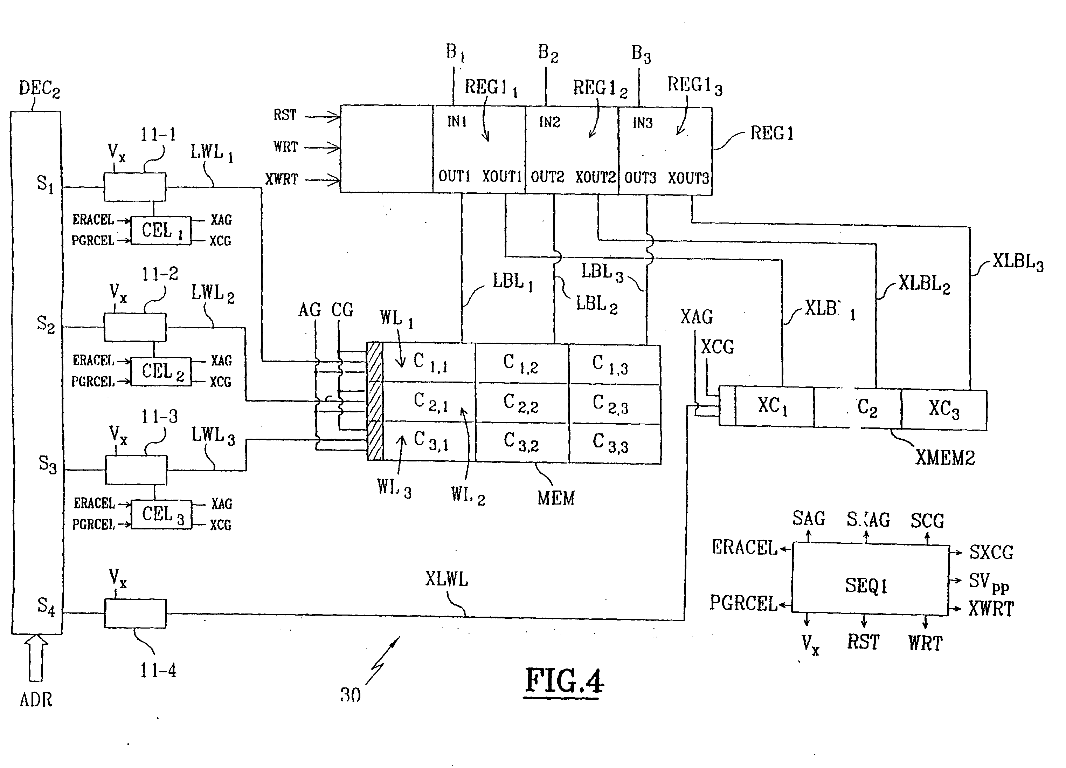

La figure 4 représente un système 30 selon l'invention comprenant une mémoire auxiliaire XMEM2 ne comprenant qu'une seule ligne de mot XWL (XWLᵢ₌₁), des fils d'accès XLBLⱼ, deux fils de commande XAG, XCG et un fil de sélection XLWL. La mémoire MEM et le registre REG1 décrits plus haut sont conservés. Le fil XLWL de sélection/activation de la ligne de mot XWL est piloté par une sortie S₄ d'un décodeur DEC2, par l'intermédiaire d'un registre 11-4 similaire aux registres 11-i décrits plus haut. Comme précédemment, le décodeur DEC2 comporte des sorties Sᵢ connectées aux fils LWLᵢ de la mémoire MEM par l'intermédiaire de registres 11-i.

Selon l'invention, chaque ligne de mot WLᵢ de la mémoire MEM est équipée d'une cellule témoin CELᵢ programmable et effaçable électriquement, qui est programmée quand la ligne de mot est effacée et effacée quand la ligne de mot est programmée.

Les étapes ERAMEM et PGRMEM se déroulent comme exposé ci-dessus et ne seront pas décrites à nouveau. Comme seule différence, la sortie S4 du décodeur DEC2 est activée pendant le déroulement des deux étapes, un signal PGRCEL est généré pendant l'étape ERAMEM et un signal ERACEL est généré pendant l'étape PGRMEM. Le signal PGRCEL est appliqué à l'ensemble des cellules CELᵢ et permet de programmer la cellule CELᵢ de la ligne de mot WLᵢ en cours d'effacement. Le signal ERACEL est appliqué à l'ensemble des cellules CELᵢ et permet d'effacer la cellule CELᵢ de la ligne de mot WLᵢ en cours de programmation. Les signaux PGRCEL et ERACEL sont par exemple délivrés par le séquenceur SEQ1 déjà décrit.

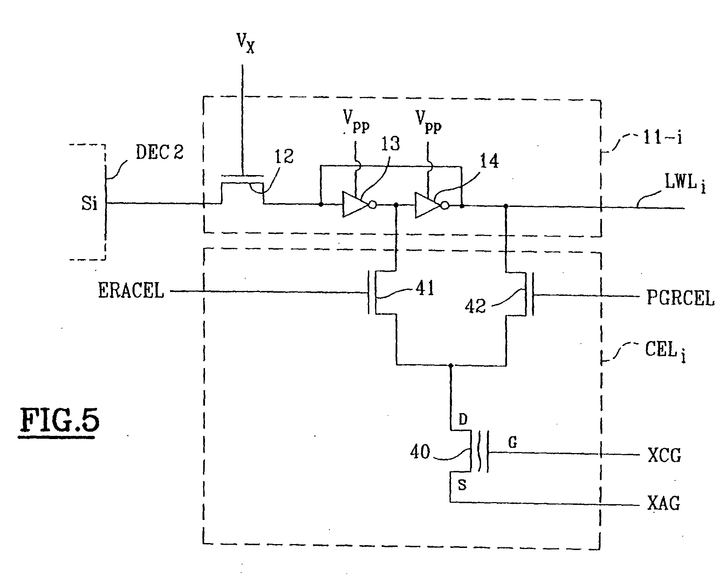

La figure 5 représente un exemple de réalisation d'une cellule témoin CELᵢ. La cellule CELᵢ comprend un transistor à grille flottante 40 dont la grille G et la source S sont connectées respectivement au fil XCG et au fil XAG de la mémoire auxiliaire XMEM2. Le drain D du transistor 40 est connecté par l'intermédiaire d'un transistor NMOS 41 à la sortie de la porte inverseuse 13 d'un registre à verrouillage 11-i (et par conséquent à l'entrée de la porte inverseuse 14 en série avec la porte 13). Le drain D du transistor 40 est également connecté par l'intermédiaire d'un transistor NMOS 42 à la sortie de la porte inverseuse 14 du registre à verrouillage 11-i. Le transistor 41 reçoit sur sa grille le signal d'effacement ERACEL et le transistor 42 reçoit sur sa grille le signal de programmation PGRCEL. De façon générale, chaque cellule témoin CELᵢ de chaque ligne de mot WLᵢ est connectée de la manière qui vient d'être décrite au registre à verrouillage 11-i qui commande le fil LWLᵢ de sélection de la ligne de mot WLᵢ.

Ainsi, au cours de l'étape ERAMEM, lorsqu'un registre 11-i est activé par le passage à la valeur 1 d'une sortie Sᵢ du décodeur DEC2, la sortie de la porte inverseuse 14 du registre 11-i délivre la tension Vpp. Simultanément, le signal PGRCEL est appliqué sur le transistor 42 et le drain D du transistor à grille flottante 40 reçoit la tension Vpp. Simultanément toujours, la grille G du transistor est connectée à la masse par le fil de commande XCG, et la source S du transistor 40 est portée à un potentiel flottant par le fil XAG (la mémoire auxiliaire XMEM2 étant en cours de programmation pour l'enregistrement d'un mot). Des charges électriques sont arrachées de la grille flottante du transistor 40 et la cellule CELᵢ passe dans l'état programmé.

Au cours de l'étape suivante PGRMEM, le registre 11-i est toujours activé et la sortie de la porte inverseuse 13 du registre 11-i est à la masse ("0" logique). Le signal ERACEL est appliqué sur le transistor 41 et le drain D du transistor à grille flottante 40 se trouve connecté à la masse. Parallèlement, la grille G du transistor 40 reçoit la tension Vpp par le fil de commande XCG, et sa source S est connectée à la masse par le fil XAG (la mémoire auxiliaire XMEM2 étant en cours d'effacement). Les charges électriques sont injectées dans la grille flottante du transistor 40 et la cellule CELᵢ passe dans l'état effacé.

Outre ces caractéristiques, les cellules témoins CELᵢ selon l'invention permettent avantageusement de sélectionner automatiquement une ligne de mot WLᵢ à programmer si une coupure d'alimentation est intervenue avant que l'étape PGRCEL n'ait été réalisée. Il n'est donc pas nécessaire de procéder à une lecture des cellules témoins pour retrouver la ligne de mot WLᵢ à programmer.

Ainsi, à la mise sous tension du système 30, on commence par lire la mémoire XMEM2. Si la mémoire auxiliaire n'est pas effacée, le mot qu'elle contient est chargé dans le registre REG1 et l'étape PGRMEM est lancée. A cet instant, seule la sortie S₄ du décodeur DEC2 est activée, pour l'effacement de la mémoire XMEM2, car l'on ne sait pas quelle est la ligne de mot WLᵢ de la mémoire MEM qui doit recevoir le mot binaire. Pour éviter un déclenchement aléatoire des registres 11-i (les portes 13 et 14 étant agencées en boucle fermée), on force à 0 les sorties Sᵢ du décodeur DEC2 (à l'exception de S₄) et l'on applique de façon transitoire le signal Vx. Le signal ERACEL étant appliqué à toutes les cellules témoins CELᵢ, les drains D de tous les transistors 40 des cellules CELᵢ se trouvent connectés à la sortie de la porte inverseuse 13 du registre 11-i correspondant, c'est-à-dire à l'entrée de la porte inverseuse 14 (voir fig. 5). Parmi les cellules témoins, une cellule est dans l'état programmé en raison de la coupure d'alimentation. Le transistor 40 de cette cellule CELᵢ est naturellement passant, de sorte que l'entrée de la porte inverseuse 14 du registre 11-i correspondant est forcée à 0 via les transistors 40, 41. La sortie de la porte inverseuse 14 passe à 1 et envoie la tension Vpp dans le fil de sélection LWLᵢ auquel elle est connectée. La ligne de mot WLᵢ correspondante est donc automatiquement activée. Dans les instants qui suivent, la cellule CELᵢ est effacée de la manière décrite plus haut et le transistor 40 n'est plus passant. Le signal ERACEL est appliqué au commencement de l'étape PGRMEM, de manière que la ligne de mot WLᵢ à programmer soit sélectionnée par la cellule CELᵢ avant que celle-ci ne s'efface. Comme les portes inverseuses 13 et 14 des registres 11-i forment un inverseur à mémoire, une impulsion à 0 sur l'entrée de la porte 14 avant que la cellule témoin ne s'efface est suffisante pour obtenir le résultat de l'invention, c'est-à-dire la sélection et l'activation de la ligne à programmer.

Dans ce qui précède, on a décrit deux modes de réalisation d'un système de mémoire selon l'invention. Divers autres modes de réalisation de l'invention peuvent être envisagés, par combinaison des deux modes de réalisation décrits.

Par exemple, si l'on ajoute des cellules témoins CELᵢ aux mémoires MEM, XMEM1 du système 10 de la figure 2, une partie de la mémoire auxiliaire XMEM1 peut être utilisée comme mémoire principale. Dans ce cas, une ligne de la mémoire principale MEM doit être réservée en tant que mémoire auxiliaire de la partie de la mémoire auxiliaire XMEM1 utilisée comme mémoire principale. En résumé, ce mode de réalisation combiné consiste à prévoir deux mémoires MEM1 et MEM2. Chaque mémoire contient une partie "mémoire principale" et une partie "mémoire auxiliaire" qui est l'auxiliaire de la partie principale de l'autre mémoire. Les parties auxiliaires de chaque mémoire peuvent ne comprendre qu'une ligne de mot, à une adresse réservée. Ce mode de réalisation permet de stocker des données dans les deux mémoires et de doubler la capacité de stockage du système.

Par ailleurs, les domaines d'applications de la présente invention sont très étendus et concernent également les compteurs de données, par exemple les compteurs d'unités présents dans les cartes à puce. On décrira ci-après deux exemples de compteurs réalisés selon le principe de l'invention.

### Application de l'invention à la réalisation d'un compteur boulier sécurisé

Le tableau ci-après illustre le fonctionnement d'un compteur classique du type boulier et décrit une opération de décrémentation d'un tel compteur. Le compteur comprend ici quatre lignes L1 à L4 de poids croissant comprenant des bits de même poids. Les bits à 1 de la ligne L1 ont par exemple un poids égal à 1, les bits à 1 de la ligne L2 un poids égal à 9, les bits à 1 de la ligne L3 un poids égal à 73, et les bits à 1 de la ligne L4 un poids égal à 585. Dans l'état initial, la valeur du compteur est 1755 (3 X 585) et à l'état suivant le compteur est décrémenté d'une unité, sa valeur étant 1754 (2 X 585 + 8 X 73).

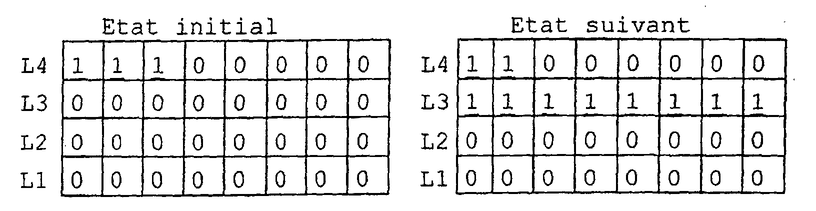

Cet exemple montre que la programmation à 0 d'un bit d'une ligne de poids fort doit être suivi, dans un compteur boulier, de l'effacement complet de la ligne de poids immédiatement inférieur. Dans l'art antérieur, si une coupure de la tension d'alimentation intervient après la programmation à 0 d'un bit d'une ligne de poids fort et avant l'effacement de la ligne de poids inférieur, le compteur présente une valeur erronée. Dans l'exemple ci-dessus, cette valeur erronée serait 1170 (2 X 585).

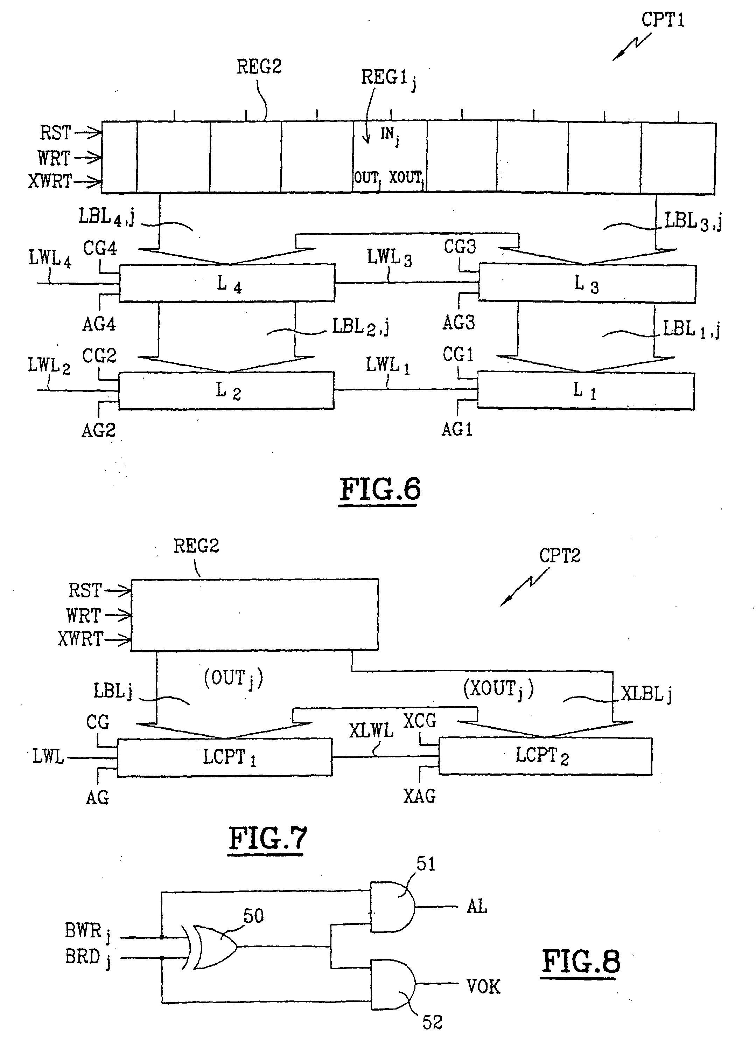

La figure 6 représente un compteur boulier CPT1 ne présentant pas cet inconvénient. Le compteur CPT1 comprend quatre lignes de comptage L₁, L₂, L₃, L₄ de poids croissants et un registre REG2. Chaque ligne Lₖ comprend par exemple huit cellules programmables et effaçables électriquement, pour enregistrer une donnée de comptage AVₖ de type boulier, ainsi qu'un fil de commande CGₖ, un fil de commande AGₖ, des fils d'accès LBL_{k,j} et un fil de sélection LWLₖ (k étant un indice désignant le rang de chaque ligne de comptage). Le registre REG2 est similaire dans sa structure au registre REG1 déjà décrit mais comporte ici huit éléments REG1ⱼ.

Selon l'invention, les lignes Lₖ sont agencées de manière que chaque ligne puisse être programmée et/ou effacée indépendamment de la ligne de rang immédiatement inférieur. Plus particulièrement, les lignes L₄ et L₃, respectivement L₂ et L₁, sont agencées en parallèle, les fils de commande LWL₄ et LWL₃ respectivement LWL₂ et LWL₁, étant connectés ensemble. Les lignes L₄ et L₂ sont agencées en série, chaque fil d'accès LBL_{4,j} étant connecté à un fil d'accès LBL_{2,j} de même rang j ainsi qu'à une sortie OUTⱼ du registre REG2. Les lignes L₃ et L₁ sont également agencées en série, chaque fil d'accès LBL_{3,j} étant connecté à un fil d'accès LBL_{1,j} de même rang j ainsi qu'à une sortie XOUTⱼ du registre REG2.

Conformément à l'invention, lorsqu'un bit d'une ligne Lᵢ (à l'exception de la ligne L₁ de plus faible poids) est programmé à 0, la ligne de rang inférieur Lᵢ₋₁ est simultanément effacée. Les avantages de l'invention tiennent ici dans le fait que les opérations d'écriture et d'effacement de deux lignes voisines sont faites simultanément.

Par exemple, l'opération de décrémentation figurant dans le tableau ci-dessus est réalisée selon les étapes suivantes (on suppose que la ligne L₄ contient la valeur "11100000" et que la ligne L3 contient la valeur "00000000") :
1) chargement du mot "11011111" dans le registre REG2 (pour une programmation à 0 individuelle du troisième bit de la ligne L₄),
2) validation des sorties OUTⱼ du registre REG2 et inhibition des sorties XOUTⱼ : le signal WRT est mis à 0 et le signal XWRT est laissé à 1, et
3) configuration des fils de commande du compteur CPT1 : CG₄ = 0, LWL₄ = Vpp, AG₄ = HZ (flottant), CG₃ = Vpp, AG₃ = 0.

Ces étapes sont réalisées de façon quasi simultanée. Ensuite, la ligne L₄ contient la valeur "11000000" et la ligne L3, effacée, contient la valeur "11111111".

Le compteur CPT1 qui vient d'être décrit convient particulièrement bien aux applications du type carte téléphonique, où les unités sont décomptées unité par unité.

Toutefois, dans certaines applications, les compteurs sont décrémentés ou incrémentés par sauts de valeur. Le compteur CPT1 se prête mal à de tels sauts de valeur car, dans ce cas, plusieurs mots doivent être enregistrés simultanément dans plusieurs lignes de comptage. Les lignes doivent être tout d'abord effacées, puis programmées, de sorte que l'on retrouve les inconvénients de l'art antérieur.

Pour pallier cet inconvénient, la présente invention propose de réaliser un compteur binaire sécurisé fonctionnant selon le principe de l'invention.

### Application de l'invention à la réalisation d'un compteur binaire sécurisé

De façon classique, un compteur binaire est un compteur dans lequel la donnée de comptage est stockée dans une ligne de comptage sous forme d'un mot binaire comprenant des bits de poids croissants selon lés puissances de deux : 1, 2, 4, 8, 16, 32, 64, 128... Les compteurs binaires ne sont généralement pas utilisés dans les cartes à puce ou dispositifs équivalents, car une coupure de la tension d'alimentation intervenant après l'effacement 'de la ligne de comptage et avant l'enregistrement d'une nouvelle donnée de comptage ferait perdre la totalité de la valeur du compteur.

La figure 7 représente un compteur binaire sécurisé CPT2 qui ne présente pas cet inconvénient. Le compteur comprend deux lignes de comptage LCPT1, LCPT₂ en parallèle, programmables et effaçables électriquement grâce au registre REG2 décrit plus haut. Chaque ligne LCPT₁, LCPT₂ comprend le même nombre de bits, par exemple 8 ou 16 bits, choisi en fonction de la capacité que l'on souhaite donner au compteur.

Dans un souci de simplicité, le compteur CPT2 est représenté schématiquement sur la figure car sa structure a été implicitement décrite dans ce qui précède. Ainsi, la structure du compteur CPT2 est celle que présente le compteur CPT1 de la figure 6 lorsque l'on supprime les lignes L1 et L2, ou L3 et L4. Egalement, la structure du compteur CPT2 est celle que présente le système 30 de la figure 4 quand la mémoire MEM ne comporte qu'une ligne de mot WLᵢ (les cellules CELᵢ n'étant plus nécessaires), la mémoire MEM formant la ligne de comptage LCPT₁ et la mémoire auxiliaire XMEM2 formant la ligne de comptage LCPT₂.

Ici, on ne déclenche pas les deux étapes ERAMEM et PGRMEM pour l'enregistrement d'une donnée de comptage, mais une seule de ces étapes, les deux lignes LCPT₁ et LCPT₂ fonctionnant en tandem. Ainsi, chaque nouvelle donnée de comptage binaire BV est enregistrée en alternance dans l'une des lignes de comptage LCPT₁, LCPT₂. Quand une nouvelle donnée de comptage BV doit être enregistrée, on recherche, parmi les deux lignes de comptage, celle qui est dans l'état effacé. On enregistre la nouvelle donnée de comptage dans cette ligne et, simultanément, on efface l'autre ligne de comptage (au cours d'une étape d'initialisation, on pourra enregistrer une donnée initiale dans l'une des lignes LCPT₁, LCPT₂ et effacer l'autre ligne). L'étape d'enregistrement de la donnée de comptage est équivalente à l'étape ERAMEM ou à l'étape PGRMEM selon que la ligne trouvée effacée est la ligne LCPT₂ ou la ligne LCPT₁. Un séquenceur du type décrit plus haut peut être prévu.

La lecture de la donnée de comptage BV peut également être faite en une seule étape, par lecture parallèle et simultanée des deux lignes LCPT₁, LCPT₂ selon un principe déjà décrit.

Enfin, l'écriture d'une nouvelle donnée de comptage dans le compteur CPT2 est de préférence assujettie à la condition que la nouvelle donnée de comptage soit inférieure, ou supérieure, à la donnée de comptage précédemment enregistrée, selon un sens de modification autorisé du compteur. La figure 8 montre que la vérification de cette condition peut être faite au moyen d'un circuit en logique câblée. Dans cet exemple, les bits BWRⱼ de la donnée de comptage à enregistrer sont comparés avec les bits BRDⱼ de même rang de la donnée de comptage précédemment enregistrée, en commençant par les bits de poids fort. Plus particulièrement, une porte OU EXCLUSIF 50 reçoit en entrée les bits BWRⱼ et BRDⱼ, une porte ET 51 reçoit en entrée la sortie de la porte 50 et les bits BWRⱼ, et une porte ET 52 reçoit en entrée la sortie de la porte 50 et les bits BRDⱼ. Le bit de sortie de la porte 51, lorsqu'il passe à 1, est considéré comme un signal d'alarme AL. L'opération d'enregistrement n'est pas effectuée. Inversement, le bit de sortie de la porte 52, lorsqu'il passe à 1, est considéré comme un signal d'autorisation VOK. Dans cet exemple, le compteur évolue dans le sens décroissant. L'enregistrement de la nouvelle donnée de comptage n'est autorisé qu'à la condition que le bit à 1 de la première paire de bits {BWRⱼ, BRDⱼ} rencontrée comprenant deux bits de valeurs différentes, soit le bit BRDⱼ.

Ici, l'étape d'enregistrement d'une nouvelle donnée de comptage dans une ligne effacée du compteur, et l'étape d'effacement de l'autre ligne de comptage, peuvent être réalisées l'une après l'autre au lieu d'être réalisées simultanément. En effet, une coupure d'alimentation électrique entre l'enregistrement de la valeur de comptage dans une ligne et l'effacement de l'autre ligne a pour seule conséquence que le compteur présente, à la mise sous tension, deux valeurs de comptage. Le compteur ayant un sens de modification prédéterminé (incrémentation ou décrémentation), il est aisé d'identifier la dernière donnée de comptage enregistrée (par une lecture séparée des deux lignes de comptage) puis d'effacer la ligne comportant la donnée de comptage la plus ancienne. La dernière donnée de comptage enregistrée est celle qui présente la plus forte ou la plus faible valeur selon le sens de modification autorisé du compteur. Ainsi, lorsqu'il s'agit d'enregistrer une donnée de comptage, et de façon plus générale d'enregistrer une donnée évoluant toujours dans le même sens ou selon une loi prédéterminée, il n'est pas impératif de réaliser simultanément les étapes d'enregistrement et d'effacement. Ce qui est essentiel, c'est qu'une ligne de comptage dans l'état effacé soit disponible lorsqu'une nouvelle donnée de comptage est enregistrée. De ce point de vue, le fractionnement dans le temps des deux étapes d'enregistrement/effacement pourrait également être envisagé dans le cas du système de mémoire 10 décrit plus haut, à la condition que chaque mot binaire enregistré contienne une indication, par exemple une date, permettant de déterminer, entre deux mots binaires de même adresse ADR se trouvant dans les mémoires MEM et XMEM1, celui qui a été enregistré le dernier.

Dans ce qui précède, on a décrit diverses variantes de réalisation du procédé d'enregistrement et du système de mémoire selon l'invention. Il apparaîtra clairement à l'homme de l'art qu'encore d'autres modes de réalisation peuvent être prévus. Par exemple, le système 30 de la figure 4 peut comporter une mémoire auxiliaire XMEM2 comprenant un nombre de lignes de mot XWLᵢ supérieur à 1 mais inférieur au nombre de lignes de mot WLᵢ de la mémoire principale MEM. Etant donné que les transistors à grille flottante présentent un vieillissement proportionnel au nombre de cycles de programmation et effacement qu'ils subissent, cette variante de réalisation permet de retarder le vieillissement de la mémoire auxiliaire XMEM2. Dans ce cas, le choix de la ligne de mot auxiliaire XWLᵢ pour la réalisation des étapes ERAMEM et PGRMEM peut être aléatoire, ou cyclique, ce qui permet de répartir le vieillissement de façon équiprobable sur toutes les lignes de la mémoire auxiliaire.

Par ailleurs, une telle variante de réalisation peut permettre d'intégrer le compteur CPT2 de la figure 7 dans le système 30 de la figure 4. Dans ce cas, une ligne de mot WLᵢ de la mémoire MEM est réservée en tant que ligne de comptage LCPT₁, et une ligne de mot XWLᵢ de la mémoire auxiliaire XMEM2 est réservée en tant que ligne de comptage LCPT₂. Bien entendu, le compteur CPT2 peut aussi être intégré dans le système 10 de la figure 2.

Enfin, l'homme de l'art notera que la présente invention est destinée à être combinée avec l'invention décrite dans la demande WO97/48100. Comme on l'a déjà rappelé au préambule, cette autre invention permet de poursuivre une opération de programmation ou d'effacement d'une ligne de mot en cas de coupure de la tension d'alimentation Vcc. La présente invention complète cette précédente invention et permet d'éviter la perte d'une donnée à enregistrer grâce à un enregistrement immédiat de la donnée dans une ligne de mot préalablement effacée. Ensemble, les deux inventions permettent de réaliser un système de mémoire EEPROM sécurisé entièrement protégé contre les coupures d'alimentation.

## Revendications

1. Procédé d'enregistrement d'un mot binaire (BW) dans une mémoire (30, CPT1, CPT2) comprenant des cellules mémoire (C_{i,j}) programmables et effaçables électriquement organisées en lignes de mot (WLᵢ, XWL), **caractérisé en ce que** les lignes de mot sont agencées de manière à former une zone mémoire principale (MEM) et une zone mémoire auxiliaire (XMEM2) en parallèle avec la zone mémoire principale, la zone mémoire auxiliaire comprenant un nombre de lignes de mot (XWL) inférieur au nombre de lignes de mot (WLᵢ) de la zone mémoire principale, et **en ce qu'**il comprend :
- une première étape d'enregistrement comprenant les étapes consistant à sélectionner à une adresse déterminée (ADR) une ligne de mot (WLᵢ) dans la zone mémoire principale (MEM), à sélectionner une ligne de mot auxiliaire (XWL) dans la zone mémoire auxiliaire, à enregistrer le mot binaire dans la ligne de mot auxiliaire (XWL) et à effacer simultanément la ligne de mot (WLᵢ) sélectionnée dans la zone mémoire principale,
- une deuxième étape d'enregistrement comprenant les étapes consistant à enregistrer le mot binaire dans la ligne de mot effacée (WLᵢ) sélectionnée dans la zone mémoire principale et à effacer simultanément la ligne de mot auxiliaire (XWL).

2. Procédé selon la revendication 1, dans lequel :
- une cellule témoin (CELᵢ) programmable et effaçable électriquement est associée à chacune des lignes de mot (WLᵢ) de la zone mémoire principale (MEM),
- la cellule témoin (CELᵢ) d'une ligne de mot (WLᵢ) de la zone mémoire principale est effacée quand la ligne de mot est programmée, et
- la cellule témoin (CELᵢ) d'une ligne de mot (WLᵢ) de la zone mémoire principale est programmée quand la ligne de mot est effacée.

3. Mémoire (30) comprenant des lignes de mot (WLᵢ) agencées de manière à former une première et une deuxième zones mémoire en parallèle, et des moyens pour effacer une ligne de mot dans l'une quelconque des deux zones mémoire tout en effectuant simultanément une opération de programmation dans l'autre zone mémoire, **caractérisée en ce que** :
- la première zone mémoire est une zone mémoire principale (MEM) accessible ligne à ligne par application d'une adresse (ADR) sur un décodeur d'adresse (DEC2),
- la deuxième zone mémoire est une zone mémoire auxiliaire (XMEM2) comprenant un nombre de lignes de mot (XWL) inférieur au nombre de lignes de mot (WLᵢ) de la zone mémoire principale (MEM), le nombre de lignes de mot de la zone mémoire auxiliaire étant au minimum égal à 1.

4. Mémoire selon la revendication 3, comprenant des moyens (SEQ1, REG1) d'écriture d'un mot binaire (BW) agencés pour :
- sur réception d'un signal d'écriture du mot binaire, sélectionner une ligne de mot dans l'une des zones mémoire et enregistrer le mot binaire dans la ligne de mot sélectionnée,
- enregistrer tout d'abord le mot binaire dans une ligne de mot auxiliaire (XWL) de la zone mémoire auxiliaire (XMEM2) et effacer simultanément une ligne de mot (WLᵢ) sélectionnée dans la zone mémoire principale (MEM), puis
- enregistrer le mot binaire dans la ligne de mot sélectionnée (WLᵢ) de la zone mémoire principale et effacer simultanément la ligne de mot auxiliaire (XWL).

5. Mémoire selon la revendication 4, comprenant :
- des cellules témoins (CELᵢ) programmables et effaçables électriquement, associées aux lignes de mot (WLᵢ) de la zone mémoire principale (MEM),
- des moyens (SEQ1, 40, 41, 42) pour effacer la cellule témoin (CELᵢ) d'une ligne de mot (WLᵢ) de la zone mémoire principale quand la ligne de mot est programmée, et pour programmer la cellule témoin (CELᵢ) d'une ligne de mot (WLᵢ) de la zone mémoire principale quand la ligne de mot est effacée.

6. Mémoire selon la revendication 5, comprenant des moyens (DEC2, CELᵢ) pour sélectionner automatiquement une ligne de mot (WLᵢ) dont la cellule témoin (CELᵢ) n'est pas effacée et enregistrer un mot binaire dans la ligne de mot sélectionnée lorsqu'une tension de programmation (Vpp) est appliquée à la mémoire.

7. Mémoire selon l'une des revendications 3 à 6, comprenant un compteur binaire (CPT2) pour stocker une donnée de comptage (VB), **caractérisé en ce** le compteur comprend :
- au moins une première ligne de comptage (LCPT₁) dans la zone mémoire principale et une deuxième ligne de comptage (LCPT₂) dans la zone mémoire auxiliaire,
- des moyens (REG2, AG, XAG, CG, XCG) pour enregistrer chaque nouvelle donnée de comptage (BV) en alternance dans la première (LCPT₁) ou la deuxième (LCPT₂) ligne de comptage, et pour effacer simultanément la ligne de comptage (LCPT₁, LCPT₂) comprenant l'ancienne donnée de comptage.

8. Mémoire selon la revendication 7, comprenant des moyens de comparaison (50, 51, 52) de chaque nouvelle donnée de comptage avec une donnée de comptage précédemment enregistrée, agencés pour empêcher l'enregistrement de la nouvelle donnée de comptage si celle-ci est inférieure ou supérieure, selon un sens de modification du compteur prédéterminé, à l'ancienne donnée de comptage.

9. Mémoire selon la revendication 8, dans laquelle les moyens de comparaison (50, 51, 52) sont agencés pour comparer bit à bit (BWRⱼ, BRDⱼ) la nouvelle donnée de comptage avec la donnée de comptage précédemment enregistrée, en commençant par les bits de poids fort.

10. Mémoire selon l'une des revendications 3 à 9, comprenant un compteur boulier (CPT1) pour stocker des mots binaires (AVₖ) de poids croissants, le compteur comprenant une pluralité de lignes de comptage (Lₖ) de poids croissants programmables et effaçables électriquement, agencées de manière que chaque ligne puisse être programmée ou effacée simultanément à l'effacement ou la programmation de la ligne de comptage de poids immédiatement inférieur, et des moyens (REG2, AG, XAG, CG, XCG, LWL) pour enregistrer une donnée de comptage dans une ligne comptage (Lₖ) et effacer simultanément la ligne de comptage (Lₖ) de poids immédiatement inférieur.

11. Mémoire selon la revendication 10, dans lequel les lignes de mot du compteur boulier sont agencées par groupes de lignes en parallèle, chaque ligne de rang donné d'un groupe de lignes en parallèle étant agencée en série avec les lignes de même rang des autres groupes.

## Patentansprüche

1. Verfahren zum Einschreiben eines Binärwortes (BW) in einen Speicher (30, CPT 1, CPT 2), umfassend programmierbare und elektrisch löschbare Speicherzellen (C_{i,j}), die in Wortzeilen (WLᵢ, XWL) angeordnet sind, **dadurch gekennzeichnet, dass** die Wortzeilen in der Art angeordnet sind, um eine Hauptspeicherzone (MEM) und eine Hilfsspeicherzone (XMEM2) parallel zu der Hauptspeicherzone zu bilden, dass die Hilfsspeicherzone eine Anzahl von Wortzeilen (XWL) umfasst, die geringer als die Anzahl der Wortzeilen (WLᵢ) der Hauptspeicherzone ist, und dass es umfasst:
- eine erste Einschreibungsstufe umfassend die Stufen bestehend aus der Auswahl mit einer festgelegten Adresse (ADR) einer Wortzeile (WLᵢ) in der Hauptspeicherzone (MEM), der Auswahl einer Hilfswortzeile (XWL) in der Hilfsspeicherzone, dem Einschreiben des Binärwortes in die Hilfswortzeile (XWL) und dem gleichzeitigen Löschen der Wortzeile (WLᵢ), die in der Hauptspeicherzone ausgewählt ist,
- eine zweite Einschreibstufe umfassend die Stufen bestehend aus dem Einschreiben des Binärwortes in die gelöschte Wortzeile (WLᵢ), die in der Hauptspeicherzone ausgewählt ist und dem gleichzeitigen Löschen der Hilfswortzeile (XWL).

2. Verfahren nach Anspruch 1, bei welchem:
- eine programmierbare und elektrisch löschbare Markierungszelle (CELᵢ) jeder der Wortzeilen (WLᵢ) der Hauptspeicherzone (MEM) zugeordnet ist,
- die Markierungszelle (CELᵢ) einer Wortzeile (WLᵢ) der Hauptspeicherzeile gelöscht wird, wenn die Wortzeile programmiert ist, und
- die Markierungszelle (CELᵢ) einer Wortzeile (WLᵢ) der Hauptspeicherzone programmiert wird, wenn die Wortzeile gelöscht ist.

3. Speicher (30) umfassend Wortzeilen (WLᵢ), die in der Art angeordnet sind, um eine erste und eine zweite Speicherzone parallel zu bilden und mit Mitteln zum Löschen einer Wortzeile in einer der zwei Speicherzonen, in dem gleichzeitig eine Programmieroperation in der anderen Speicherzone bewirkt wird, **dadurch gekennzeichnet,**
- **dass** die erste Speicherzone eine Hauptspeicherzone (MEM) ist, auf die Zeile für Zeile durch Anlegen einer Adresse (ADR) über einen Adressendekodierer (DEC2) zugegriffen werden kann,
- **dass** die zweite Speicherzone eine Hilfsspeicherzone (XMEM2) ist, die eine Anzahl von Wortzeilen (XWL) umfasst, die geringer als die Anzahl der Wortzeilen (WLᵢ) der Hauptspeicherzone (MEM) ist, wobei die Anzahl der Wortzeilen der Hilfsspeicherzonen im Minimum dem Wert 1 entspricht

4. Speicher nach Anspruch 3, umfassend Mittel (SEQ1, REG1) zum Einschreiben eines Binärwortes (BW) und ausgerüstet, um
- beim Empfang eines Schreibsignales des Binärwortes eine Wortzeile in einer der Speicherzonen auszuwählen und das Binärwort in die ausgewählte Wortzeile einzuschreiben,
- zuallererst das Binärwort in eine Hilfswortzeile (XWL) der Hilfsspeicherzone (XMEM2) einzuschreiben und gleichzeitig eine in der Hauptspeicherzone (MEM) ausgewählte Wortzeile (WLᵢ) zu löschen, und dann
- das Binärwort in die Wortzeile (WLᵢ) einzuschreiben, die in der Hauptspeicherzone ausgewählt ist und gleichzeitig die Hilfswortzeile (XWL) zu löschen.

5. Speicher nach Anspruch 4, umfassend:
- programmierbare und elektrisch löschbare Markierungszellen (CELᵢ), die den Wortzeilen (WLᵢ) der Hauptspeicherzone (MEM) zugeordnet sind,
- Mittel (SEQ1, 40, 41, 42) zum Löschen der Markierungszelle (CELᵢ) einer Wortzeile (WLᵢ) der Hauptspeicherzone, wenn die Wortzeile programmiert ist, und um die Markierungszelle (CELᵢ) einer Wortzeile (WLᵢ) der Hauptspeicherzone zu programmieren, wenn die Wortzeile gelöscht ist.

6. Speicher nach Anspruch 5, umfassend Mittel (DEC2, CELᵢ) für automatischen Auswahl einer Wortzeile (WLᵢ), deren Markierungszelle (CELᵢ) nicht gelöscht ist und zum Einschreiben eines Binärwortes in die ausgewählte Wortzeile, wenn eine Programmierspannung (Vpp) an den Speicher angelegt ist.

7. Speicher nach einem der Ansprüche 3 bis 6, umfassend einen Binärzähler (CPT2) zum Ansammeln einer Zählangabe (VB), **dadurch gekennzeichnet, dass** der Zähler umfasst:
- wenigstens eine erste Zählreihe (LCPT₁) in der Hauptspeicherzone und eine zweite Zählreihe (LCPT₂) in der Hilfsspeicherzone,
- Mittel (REG2, AG, XAG, CG, XCG) zum Einschreiben jeder neuen Zählangabe (BV) abwechselnd in die erste (LCPT₁) oder in die zweite (LCPT₂) Zählreihe und zum gleichzeitigen Löschen der Zählreihe (LCPT₁, LCPT₂), die die alte Zählangabe enthält.

8. Speicher nach Anspruch 7, umfassend Vergleichsmittel (50, 51,52) für jede neue Zählangabe mit einer zuvor eingeschriebenen Zählangabe, ausgerüstet um die Einschreibung der neuen Zählangabe zu verhindern, wenn diese geringer oder höher als die alte Zählangabe gemäß einer vorbestimmten Zählmodifikation ist.

9. Speicher nach Anspruch 8, bei welchem die Vergleichsmittel (50, 51, 52) ausgerüstet sind, um Bit für Bit (BWRⱼ, BRDⱼ) die neue Zählangabe mit der zuvor eingeschriebenen Zählangabe beginnend mit den hochgewichteten Bits zu vergleichen.

10. Speicher nach einem der Ansprüche 3 bis 9, umfassend einen Rechenzähler (CPT1) zum Ansammeln der Binärworte (AVₖ) mit wachsendem Gewicht, wobei der Zähler mehrere Zählreihen (Lₖ) mit wachsendem Gewicht umfasst, die programmierbar und elektrisch löschbar sind, ausgerüstet in der Art, dass jede Reihe programmiert oder gelöscht werden kann gleichzeitig mit dem Löschen oder der Programmierung der Zählreihe mit dem unmittelbar darunter liegenden Gewicht und mit Mitteln (REG2, AG, XAG, CG, XCG, LWL) zum Einschreiben einer Zählangabe in eine Zählreihe (Lₖ) und zum gleichzeitigen Löschen der Zählreihe (Lₖ) mit dem unmittelbar darunter liegenden Gewicht.

11. Speicher nach Anspruch 10, bei welchem die Wortzeilen des Rechenzählers in parallelen Zeilengruppen angeordnet sind, und dass jede Zeile von gegebenem Rang einer parallelen Zeilengruppe in Reihe mit den Zeilen vom gleichen Rang der anderen Gruppen angeordnet ist.

## Claims

1. A method of recording a binary word (BW) in a memory (30, CPT1, CPT2) including memory cells (C_{i,j}) which are electrically programmable and erasable and organised in word lines (WLᵢ, XWL), **characterised in that** the word lines are arranged so as to form a main memory area (MEM) and an auxiliary memory area (XMEM2) in parallel with the main memory area, the auxiliary memory area including a number of word lines (XWL) which is less than the number of word lines (WLᵢ) of the main memory area, and **in that** it includes:
- a first recording step including the steps of selecting at a determined address (ADR), a word line (WLᵢ) in main memory area (MEM), selecting an auxiliary word line (XWL) in the auxiliary memory area, recording the binary word in auxiliary word line (XWL) and simultaneously erasing the word line (WLᵢ) selected in the main memory area,
- a second recording step including the steps of recording the binary word in erased word line (WLᵢ) selected in the main memory area and simultaneously erasing auxiliary word line (XWL).

2. The method according to Claim 1, in which:
- an electrically programmable and erasable reference cell (CELᵢ) is attached to each word line (WLᵢ) of main memory area (MEM),
- reference cell (CELᵢ) of a word line (WLᵢ) of the main memory area is erased when the word line is programmed, and
- reference cell (CELᵢ) of a word line (WL1 ) of the main memory area is programmed when the word line is erased.

3. A memory (30) including word lines (WLᵢ) arranged so as to form first and second parallel memory areas, and means for erasing a word line in any one of the two memory areas while simultaneously carrying out a programming operation in the other memory area,
**characterised in that:**
- the first memory area is a main memory area (MEM) accessible line by line by applying an address (ADR) to an address decoder (DEC2),
- the second memory area is an auxiliary memory area (XMEM2) including a number of word lines (XWL) which is less than the number of word lines (WLᵢ) of main memory area (MEM), the number of word lines of the auxiliary memory area being at least equal to 1.

4. The memory according to Claim 3, including means (SEQ1, REG1) for writing a binary word (BW) arranged to:
- select, upon receiving a signal for writing the binary word, a word line in one of the memory areas and record the binary word in the selected word line,
- record firstly the binary word in an auxiliary word line (XWL) of auxiliary memory area (XMEM2) and simultaneously erase a word line (WLᵢ) selected in main memory area (MEM), then
- record the binary word in selected word line (WLᵢ) of the main memory area and simultaneously erase auxiliary word line (XWL).

5. The memory according to Claim 4, including:
- electrically programmable and erasable reference cells (CELᵢ) attached to the word lines (WLᵢ) of main memory area (MEM),
- means (SEQ1, 40, 41, 42) for erasing reference cell (CELᵢ), of a word line (WLᵢ) of the main memory area when the word line is programmed, and for programming reference cell (CELᵢ) of a word line (WLᵢ) of the main memory area when the word line is erased.

6. The memory according to Claim 5, including means (DEC2, CELᵢ) for automatically selecting a word line (WLᵢ), reference cell (CELᵢ) of which is not erased and recording a binary word in the selected word line when a programming voltage (Vpp) is applied to the memory.

7. The memory according to one of Claims 3 to 6, including a binary counter (CPT2) for storing count data (VB), **characterised in that** the counter includes:
- at least a first count line (LCPT₁) in the main memory area and a second count line (LCPT₂) in the auxiliary memory area,
- means (REG2, AG, XAG, CG, XCG) for recording each new count data (BV) alternately in first (LCPT₁) or second (LCPT₂) count line, and for simultaneously erasing count line (LCPT₁, LCPT₂) including the old count data.

8. The memory according to Claim 7, including means (50, 51, 52) for comparing each new count data to a previously recorded count data, arranged to prevent the recording of the new count data if it is less or more, according to a modification direction of the predetermined counter, than the old count data.

9. The memory according to Claim 8, in which comparison means (50, 51, 52) are arranged to compare bit by bit (BWRⱼ, BRDⱼ) the new count data to the previously recorded count data, starting with the most significant bits.

10. The memory according to one of Claims 3 to 9, including an abacus counter (CPT1) for storing binary words (AVₖ) of increasing significance, the counter including a plurality of count lines (Lₖ) of increasing significance which are electrically programmable and erasable and arranged so that each line can be programmed or erased while simultaneously erasing or programming the next less significant count line, and means (REG2, AG, XAG, CG, XCG, LWL) for recording a count data in a count line (Lₖ) and simultaneously erasing next less significant count line (Lₖ).

11. The memory according to Claim 10, in which the word lines of the abacus counter are arranged in parallel line groups, each given row line of a parallel line group being arranged in series with the lines of the same row of the other groups.
